# EUROPEAN PATENT SPECIFICATION

(11) **EP 2 533 271 B1**
(45) Date of publication and mention of the grant of the patent: **21.05.2014**
(21) Application number: 12171194.9
(22) Date of filing: 07.06.2012
(51) Int. Cl.: H01L 21/288, C25D 17/00

(54) **An ecpr master electrode, and a method for providing such master electrode**
ECPR-Masterelektrode und Verfahren zur Bereitstellung solch einer Masterelektrode
Électrode maître ECPR et procédé permettant de fournir une telle électrode maître

(30) Priority: 07.06.2011 EP 11290260
(43) Date of publication of application: 12.12.2012
(73) Proprietor: Centre de Recherche Public - Gabriel Lippmann, 4422 Belvaux (LU)
(72) Inventor: Dainese, Matteo, 69410 Champagne au Mont d'Or (FR); Fredenberg, Mikael, 112 45 STOCKHOLM (SE); Möller, Patrik, 112 32 STOCKHOLM (SE); Chantelauze, Simon, 69410 Champagne au Mont d'or (FR); Kennedy, Tim, 38000 GRENOBLE (FR); Cuthbertson, Alan, 38320 HERBEYS (FR)
(74) Representative: Wagner, Jean-Paul

(56) References cited:
- JP-A- 2005 256 110
- US-A1- 2004 182 716

## Description

### FIELD OF THE INVENTION

The present invention relates to an ECPR master electrode, and a method for providing such master electrode. More particularly, the present invention relates to a circular ECPR master electrode.

### BACKGROUND ART

WO 02/103085 and WO 2007058603 relate to an electrochemical pattern replication process, ECPR, and the construction of a master electrode for production of appliances involving micro and nano structures using ECPR. An etching or plating pattern, which is defined by the master electrode, is replicated on an electrically conductive material, commonly denoted as a substrate. During ECPR, the master electrode is put in close contact with the substrate and the etching/plating pattern is directly transferred onto the substrate by an etching/plating process. The contact etching/plating process is performed in local etching/plating cells, which are formed in cavities between the master electrode and the substrate.

The cavities are provided as electrochemical cells having an open end at the upper surface of the master electrode, and extending downwards. Hence, the upper surface of the master electrode includes a topographical pattern defining at least one electrochemical cell, wherein the bottom of each cell is provided with an electrically conducting material. During ECPR, each cell is filled with an electrolyte solution, for allowing conducting ions of the conducting material to be transferred from the bottom of each cell to the substrate to be patterned.

The area between the electrochemical cells, i.e. the uppermost area of the topographical pattern of the master electrode is provided with an insulating layer for preventing unwanted parasitic currents during the ECPR process. Hence, ECPR will only provide pattern transfer at the positions being defined by the electrochemical cells.

Before the master electrode is used in the ECPR, the electrochemical cells need to be prefilled with a conductive material. Usually, the thickness of the prefilled material is in the range of 0,5 to 10 micrometers, depending on the specific application. During the ECPR the conductive material is transferred from the bottom of the electrochemical cells of the master electrode to the substrate being plated. Thus, when the master electrode is separated from the processed substrate the prefilled conductive material is arranged on the substrate.

The master electrode may be made of a carrier element of a durable material, since the master electrode should be used for a plurality of processes of etching or plating. One such material is Si, which allows the master electrode to be manufactured by well established and high yield semiconductor processes. Consequently, in many cases circular Si wafers form the carrier elements of ECPR master electrodes.

For the chip industry, the topographical pattern of the master electrode may be arranged in a planar distribution across the master electrode surface, wherein the planar distribution includes a number of rectangular sub-areas. In such application, each rectangular sub-area may define a chip. Hence, the master electrode may be provided with a topographical pattern being periodic and defining a plurality of adjacently arranged rectangular chips. The rectangular shape of each chip is usually necessary because of the need for facilitated dicing and chip separation later in the device manufacturing process.

During ECPR, current will flow radially through the master electrode to the seeded substrate and out via an external connection at the edge of the substrate. If the pattern density across the master electrode is exhibiting variations close to the edge of the circular carrier element, this may result in uneven plating thickness across the substrate being processed by ECPR due to non-uniform current flow. Thus, the chips having a position corresponding to the central part of the master electrode will be different from the chips having a position corresponding to the more peripheral part of the master electrode. Quality may therefore vary between different chips.

US 2004/0182716 describes a conformable electroplating contact mask, having die-pattern regions. It may be passivated in its peripheral region, by a dielectric or shielding material, against inducing treatment to a substrate.

### SUMMARY OF THE INVENTION

Accordingly, the present invention seeks to mitigate, alleviate or eliminate one or more of the above-identified deficiencies and to provide an improved ECPR master electrode as well as a method for manufacturing such master electrode.

It is an object of the present invention to provide a circular ECPR master electrode to be used in rectangular chip fabrication.

It is a further object of the present invention to provide a method for manufacturing such master electrode using a simple lithographic process, which may be done by standard semiconductor process equipment.

It is a further object of the present invention to provide a method for manufacturing such master electrode while allowing for uniform quality of the manufactured chips.

It is an idea of the present invention to provide a circular ECPR master electrode having a first topographical pattern defining electrochemical cells arranged in a periodic rectangular pattern, and a second topographical pattern arranged at the periphery of said first topographical pattern for creating a peripheral part of the topographical pattern.

According to a first aspect of the invention an ECPR master electrode is provided. The master electrode comprises a circular carrier element having an electrically conducting electrode surface on a back side and a topographical pattern with an at least partly electrically insulating top on a front side of said carrier element, said topographical pattern comprising a plurality of electrochemical cells in said carrier element, each one of said electrochemical cells comprising a bottom and at least one side wall, said bottom having an electrically conducting surface being conductively connected to the electrically conducting electrode surface through the carrier element, wherein said topographical pattern comprises a chip pattern and a dummy pattern, and wherein said chip pattern is distributed across a device area comprising at least one rectangular chip area, while said dummy pattern is distributed across a dummy area surrounding said device area.

Said device area may comprise a plurality of adjacently arranged rectangular chip areas. Hence, stepper or scanner technology may be utilized for defining the device area.

Said dummy pattern may be arranged as a periodic repetition of a predetermined pattern density which is advantageous in that the pattern density of the dummy pattern may be easily determined and adjusted for different chip patterns.

Said dummy area may be terminated by a circular periphery. Hence, the dummy pattern will be angularly symmetrical and consequently provide similar effect on the ECPR process on the complete substrate area.

Said dummy area may comprise a plurality of sub dummy areas, wherein the dimensions of each sub area is less than the dimensions of the chip areas. Hence, scanner or stepper technology may be utilized for defining the dummy area.

The topographical pattern may be extending radially across the front side of said carrier element from a centrally aligned position towards the edge of said carrier element, and wherein the carrier element comprises an annular recess outside the circular topographical pattern. Said annular recess may extend to the edge of the carrier element. This is advantageous in that enough room is provided such that the substrate may be electrically contacted during ECPR, i.e. when the substrate is in close contact with the master electrode.

According to a second aspect of the invention, a method for providing an ECPR master electrode is provided. The method comprises the step of providing a circular carrier element having an electrically conducting electrode surface on a back side and a topographical pattern with an at least partly electrically insulating top on a front side of said carrier element, said topographical pattern comprising a plurality of electrochemical cells in said carrier element, each one of said electrochemical cells comprising a bottom and at least one side wall, said bottom having an electrically conducting surface being conductively connected to the electrically conducting electrode surface on the back side through the carrier element, wherein the step of providing said topographical pattern comprises distributing said topographical pattern across a chip pattern and a dummy pattern, and distributing said chip pattern across a device area comprising at least one rectangular chip area, while distributing said dummy pattern across a dummy area surrounding said device area.

Said topographical pattern may be provided by a first lithography process defining said device area, and a second lithography step defining said dummy area.

Said first or second lithography process may be a stepper or scanner process.

The method may further comprise the step of providing an annular recess extending from the edge of the carrier element towards the dummy area.

The advantages of the first aspect of the invention are also applicable for the second aspect of the invention.

### BRIEF DESCRIPTION OF THE DRAWINGS

Hereinafter, the invention will be described with reference to the appended drawings, wherein:
Fig. 1 is a top view of an ECPR master electrode;
Fig. 2 is a side view of a master electrode and a substrate during ECPR;
Fig. 3 is a schematic top view of a master electrode according to an embodiment; and
Fig. 4 is a schematic top view of a master electrode according to a further embodiment.

### DESCRIPTION OF EMBODIMENTS

Below, several embodiments of the invention will be described with references to the drawings. These embodiments are described in illustrating purpose in order to enable a skilled person to carry out the invention and to disclose the best mode. However, such embodiments do not limit the invention, but other combinations of the different features are possible within the scope of the invention.

Some general remarks are given below with regard to the master electrode and methods of forming the master electrode. Several methods are described for forming a master electrode that can be used for producing one or multiple layers of structures of one or multiple materials including using the ECPR technology described below. The methods generally include: forming a master electrode from a carrier element which is conducting and/or semiconducting in at least some parts; forming a conducting electrode layer which functions as anode in ECPR plating and cathode in ECPR etching on a front side of the master electrode; and forming an insulating pattern layer that defines the cavities in which ECPR etching or plating can occur in the ECPR process on said front side, such that conducting electrode surface(s) is/are obtained in the bottom of the cavities; in a way that makes possible electrical contact from an external power supply to the back side of the master electrode for allowing electron transfer through the master electrode to the front side thereof to the conducing electrode surface(s), such that said surface(s) will constitute anode(s) in ECPR plating and cathode(s) in ECPR etching.

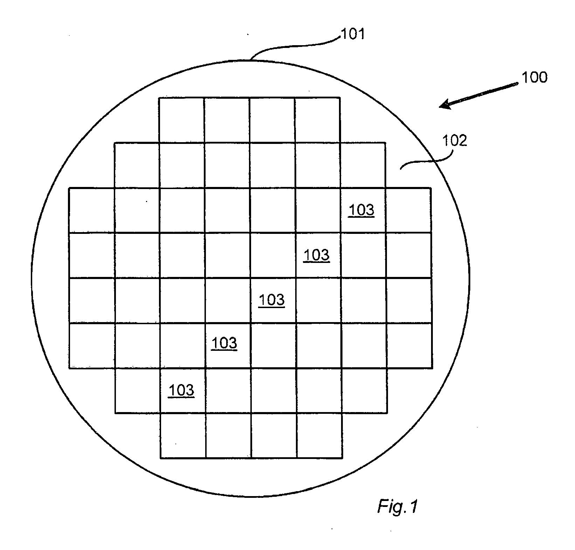

Now referring to Fig. 1, a top view of a master electrode 100 is shown. The master electrode 100 is formed by an at least partly electrically semiconducting circular carrier element 101, such as a Si wafer. The size of the carrier element may vary depending on the dimensions of the ECPR equipment to be used, but is typically of the size of standard semiconducting wafers, such as 100, 150, 200, 250, or 300 mm (4, 6, 8, 10, or 12 inches) in diameter. The upper surface 102 of the master electrode 100 is divided into a plurality of rectangular segments 103, each segment 103 defining a device pattern, such as a chip layer, to be transferred to a substrate during an ECPR process.

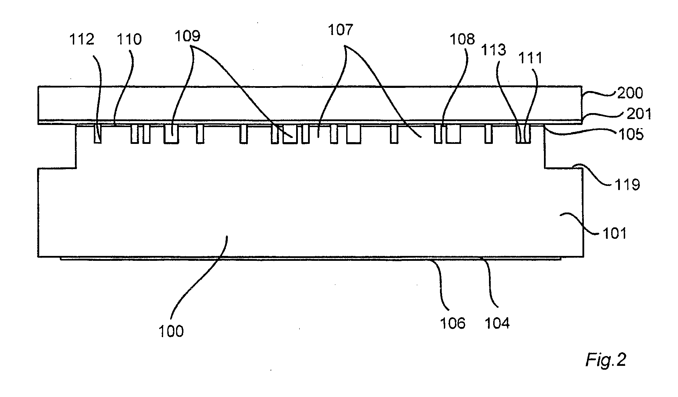

Now turning to Fig. 2, a side view of the master electrode 100 is schematically shown when arranged in close contact with a substrate 200 to be plated during ECPR. It should be noted that the master electrode and the substrate shown in this figure are not to scale, but shown only to illustrate different features in a suitable way. The carrier element 101 extends between a back side 104 and a front side 105, in such a way that electrical current is able to flow between the back side 104 and the front side 105. The carrier element 101 extends between a back side 104 and a front side 105, in such a way that electrical current is able to flow between the back side 104 and the front side 105. At the back side 104, an electrode layer 106 of an electrically conducting material is arranged. The electrode layer 106 may be formed by nickel silicide, or any other conducting material being suitable for a back side electrode layer during ECPR.

The front side 105 comprises a topographical pattern 107 with an at least partly electrically insulating top 108. The topographical pattern 107 is forming a plurality of electrochemical cells 109. That is, the planar surface extending between two adjacent electrochemical cells 109 is covered by an electrically insulating layer 110.

Each electrochemical cell comprises a bottom 111 and at least one side wall 112 extending from the bottom 111 to the electrically insulating top 108. The sidewall of the cavity is covered with an electrically insulating layer which extends from the surface insulating layer 110 to the point at which the sidewall meets the bottom of the cavity 111. The bottom 111 has an electrically conducting surface 113 being conductively connected to the electrically conducting electrode surface 106 on the back side 104 by means of the carrier element 101. Thus, the carrier element 101 is disposed between the conducting electrode surface 106 and the electrically conducting surface 113. The conductive surface 113 is formed by any material being suitable as an anode/cathode in the ECPR. Preferably, the conductive surface 113 may be formed by a self-aligned silicidation process.

The topographical pattern 107 extends from the center of the carrier element 101 radially towards the edge of the carrier element 101 and ends at a circular periphery arranged at a specific distance from the edge of the carrier element. The outer area 119 of the carrier element 101 not being occupied by the topographical pattern 107 is recessed such that the outer area is not in close contact with a substrate during ECPR. Preferably, the radial distance between the outer periphery of the topographical pattern 107 and the edge of the carrier element 101 is between 2.5 mm and 10 mm, and the width of the recessed part 119 of the carrier element is preferably 2 to 5 mm. The annular recess 119 is formed by using a resist mask and a deep silicon etch or by mechanical grinding or dicing of the carrier element 101. Preferably the depth of the recess region 119 is between 100 and 200 microns deep. The recessed part 119 of the carrier element 101 is formed in order to provide enough space for arranging an electrode at the edge of the substrate to be plated during ECPR, without touching or damaging the master electrode. Furthermore, the surfaces of the recessed region 119 are passivated with an insulating material such as silicon dioxide or silicon nitride so that the electrodes connected to the substrate are not electrically connected to the master electrode.

The surfaces of the region outside of the topological pattern 107 including the recessed portion 119 of the carrier element and the edge of the carrier element 101 are passivated with an electrically insulating material. This prevents unwanted parasitic current flowing at the edges of carrier during the ECPR pattern transfer.

During ECPR, the master electrode 100 is put in close contact with a substrate 200 to be plated. The substrate 200 is provided with a seed layer 201 of electrically conductive material, such that conductive ions may be plated onto said seed layer 201.

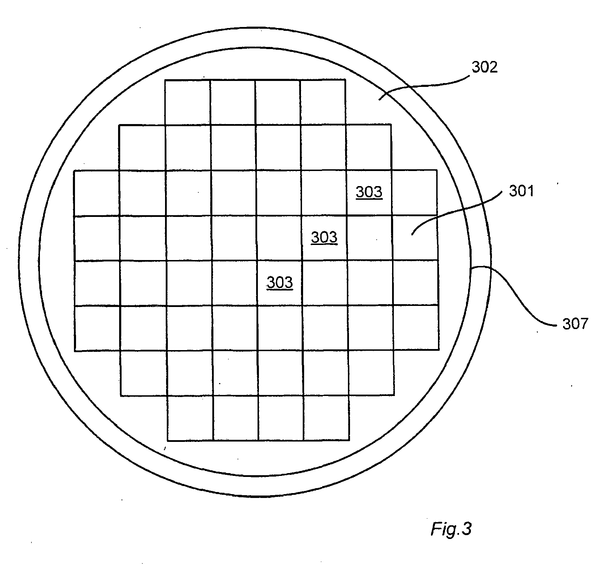

Now turning to Fig. 3, a top view of an ECPR master electrode 300 is shown. The master electrode 300 has a topographical pattern 307 on the front side, i.e. the side of the master electrode 300 that will face the substrate to be plated during ECPR. The topographical pattern 307 is distributed circularly across a device area 301 and a dummy area 302. Thus, the topographical pattern 307 may comprise the device area 301 and the dummy area 302. The device area 301 comprises a plurality of adjacently arranged rectangular chip areas 303, and the dummy area 302 surrounds said device area 301 such that the outer periphery of the topographical pattern 307 is circular. The chip areas 303 may have the same topographical pattern, such that the device area 301 comprises a number of repeated rectangular chip areas 303. In this way several chips, intended for the same use and application, may be manufactured in a single printing step.

The dummy area 302 of the topographical pattern 307 comprises a distribution of electrochemical cells representing dummy features, i.e. features not being used as device components but only for providing process stability or uniformity during ECPR. In this case, the dummy features are simple patterns preferably arranged periodically, such as holes/pillars, lines/spaces, etc., wherein the pattern density of the dummy features corresponds to the pattern density of the chip areas 303. Consequently, the current flow will be uniform at the edge of the device area 301 during ECPR, and the plating thickness will thus be homogenous over the complete device area 301.

The master electrode 300 of Fig. 3 is preferably manufactured by a lithographic process involving two separate exposure steps. At a first step, the device area 301 is provided by stepper or scanner technology, which is a well established process for providing rectangular chip pattern on a semiconducting carrier element, such as a Si wafer. A stepper or scanner may here be used for providing the chip pattern with low defectivity and high resolution. As a second step, a mask aligner may be used for providing non-critical dummy features which have a pattern density being matched to the stepper/scanner pattern. Preferably, the two-step lithographic process allows for automatic alignment of the dummy pattern to the stepper/scanner pattern using alignment marks. Preferably, the carrier element is subject to an etching process when the critical features and the dummy features have been defined on the carrier element, such that the complete topographical pattern is etched in a single step.

The pattern density of the device area 301 is usually in the range of 10 to 80 percent, and the pattern density of the dummy area 302 is thus preferably matched to this value. In a preferred embodiment, the pattern density of the dummy area 302 corresponds to the pattern density of the device area 301 ± 10%.

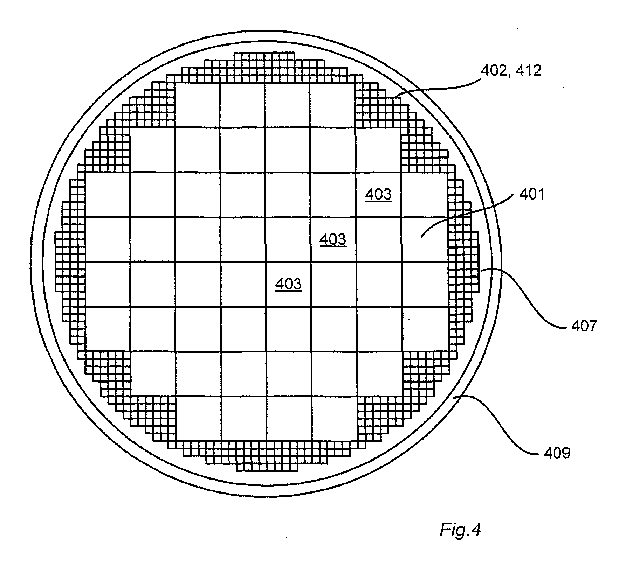

Now turning to Fig. 4, a top view of an ECPR master electrode 400 according to another embodiment is shown. The master electrode 400 has a topographical pattern 407 on the front side, i.e. the side of the master electrode 400 that will face the substrate to be plated during ECPR. The topographical pattern 407 is distributed across a device area 401 and a dummy area 402. The device area 401 comprises a plurality of adjacently arranged rectangular chip areas 403, and the dummy area 402 surrounds said device area 401. The chip areas 403 may have the same topographical pattern, such that the device area 401 comprises a number of repeated rectangular chip areas 403. In this way several chips, intended for the same use and application, may be manufactured in a single printing step. The dummy area 402 equally comprises a multitude of individual and rectangular sub dummy areas 412, such that the outer periphery of the topographical pattern 407 is approximately circular by means of a stepped pattern. The dimensions of the individual and rectangular sub dummy area 412 are much less than the dimensions of the rectangular chips 403.

The dummy area 402 of the topographical pattern 407 comprises a distribution of electrochemical cells representing dummy features, i.e. features not being used as device components but only for providing process stability or uniformity during ECPR. In this case, the dummy features are simple patterns, such as holes/pillars, lines/spaces, etc. These patterns may be repeated over the dummy area 402, such that the pattern density of the dummy features corresponds to the pattern density of the chip areas 403. Consequently, the current flow will be uniform at the edge of the device area 401 during ECPR, and the plating thickness will thus be homogenous over the complete device area 401.

The master electrode 400 of Fig. 4 is preferably manufactured by a lithographic process involving two separate exposure steps. At a first step, the device area 401 is provided by stepper or scanner technology, which is a well established process for providing rectangular chip pattern on a semiconducting carrier element, such as a Si wafer. The stepper scanner may here be used for providing the chip pattern with low defectivity and high resolution such that the chip pattern extends to the edge of the carrier element. After exposure of the pattern 403 a second mask is used on the stepper to expose the dummy pattern 402. The second exposure on the stepper is preferably performed without unloading the wafer in order to obtain excellent alignment between the two patterns 403 and 402. The size of the exposure field for the dummy pattern is made small compared to the size of the die in region 403 so that the pattern is terminated in a near circular pattern.

Preferably, the carrier element is subject to an etching process when the critical features and the dummy features have been defined on the carrier element, such that the complete topographical pattern is etched in a single step.

The recessed portion 409 of the carrier element 403 is preferably created before patterning of the patterns 401 and 402. The preferred methods for creating the annular recess 409 include lithography using a mask aligner followed by deep silicon etching, or by dicing using a custom designed dicing blade.

It is readily understood that all references to lower/upper are merely for illustrative purposes, without any limiting effect on the scope of protection.

In the claims, the term "comprises/comprising" does not exclude the presence of other elements or steps. Additionally, although individual features may be included in different claims, these may possibly advantageously be combined, and the inclusion in different claims does not imply that a combination of features is not feasible and/or advantageous. In addition, singular references do not exclude a plurality. The terms "a", "an", "first", "second" etc do not preclude a plurality. Reference signs in the claims are provided merely as a clarifying example and shall not be construed as limiting the scope of the claims in any way.

## Claims

1. An ECPR master electrode (100, 400), comprising
a circular carrier element (101) having an electrically conducting electrode surface (106) on a back side (104) and a topographical pattern (107, 407) with an at least partly electrically insulating top (108) on a front side (105) of said carrier element (101),
said topographical pattern comprising a plurality of electrochemical cells (109) in said carrier element (101), each one of said electrochemical cells comprising a bottom (111) and at least one side wall (112), said bottom having an electrically conducting surface (113) being conductively connected to the electrically conducting electrode surface (106) through the carrier element (101), wherein
said topographical pattern (107, 407) comprises a chip pattern and a dummy pattern, and wherein
said chip pattern is distributed across a device area (301, 401) comprising at least one rectangular chip area (303, 403), while said dummy pattern is distributed across a dummy area (302, 402) surrounding said device area (301, 401).

2. The ECPR master electrode according to claim 1, wherein said device area (301, 401) comprises a plurality of adjacently arranged rectangular chip areas (303, 403).

3. The ECPR master electrode according to claim 1 or 2, wherein said dummy pattern is arranged as a periodic repetition of a predetermined pattern density.

4. The ECPR master electrode according to any one of claims 1 to 3, wherein said dummy area (302) is terminated by a circular periphery.

5. The ECPR master electrode according to any one of claims 1 to 3, wherein said dummy area (402) comprises a plurality of sub dummy areas (412), wherein the dimensions of each sub area (412) is less than the dimensions of the chip areas (303, 403).

6. The ECPR master electrode according to any one of claims 1 to 5, wherein the topographical pattern (107, 407) is extending radially across the front side of said carrier element (101) from a centrally aligned position towards the edge of said carrier element (101), and wherein the carrier element (101) comprises an annular recess outside the circular topographical pattern (107, 407).

7. The ECPR master electrode according to claim 6, wherein said annular recess extends to the edge of the carrier element (101).

8. A method for providing an ECPR master electrode, comprising the step of:
providing a circular carrier element having an electrically conducting electrode surface on a back side and a topographical pattern with an at least partly electrically insulating top on a front side of said carrier element, said topographical pattern comprising a plurality of electrochemical cells in said carrier element, each one of said electrochemical cells comprising a bottom and at least one side wall, said bottom having an electrically conducting surface being conductively connected to the electrically conducting electrode surface on the back side through the carrier element,
wherein the step of providing said topographical pattern comprises:
distributing said topographical pattern across a chip pattern and a dummy pattern, and
distributing said chip pattern across a device area comprising at least one rectangular chip area, while distributing said dummy pattern across a dummy area surrounding said device area.

9. The method according to claim 8, wherein said topographical pattern is provided by a first lithography process defining said device area, and a second lithography step defining said dummy area.

10. The method according to claim 9, wherein said first lithography process is a stepper or scanner process.

11. The method according to claim 9 or 10, wherein said second lithography process is a stepper process, scanner process, or a mask aligner process.

12. The method according to any one of claims 8 to 11, further comprising the step of providing an annular recess extending from the edge of the carrier element towards the dummy area.

## Patentansprüche

1. ECPR-Masterelektrode (100, 400), umfassend
ein kreisförmiges Trägerelement (101), das eine elektrisch leitende Elektrodenoberfläche (106) an einer Rückseite (104) und eine topographische Struktur (107,407) mit einer mindestens teilweise elektrisch isolierenden Oberseite (108) an einer Vorderseite (105) dieses Trägerelements (101) aufweist,
wobei die topographische Struktur eine Vielzahl elektrochemischer Zellen (109) in dem Trägerelement (101) umfasst, wobei jede der elektrochemischen Zellen einen Boden (111) und mindestens eine Seitenwand (112) umfasst, wobei der Boden eine elektrisch leitende Oberfläche (113) aufweist, die mit der elektrisch leitenden Elektrodenoberfläche (106) durch das Trägerelement (101) hindurch leitfähig verbunden ist, wobei
die topographische Struktur (107,407) eine Chipstruktur und eine Blindelementstruktur umfasst, und wobei
die Chipstruktur über einen Vorrichtungsbereich (301, 401) verteilt ist, der mindestens einen rechteckigen Chipbereich (303, 403) umfasst, während die Blindelementstruktur über einen Blindelementbereich (302, 402) verteilt ist, der den Vorrichtungsbereich (301, 401) umgibt.

2. ECPR-Masterelektrode nach Anspruch 1, wobei der Vorrichtungsbereich (301, 401) eine Vielzahl benachbart angeordneter rechteckiger Chipbereiche (303, 403) umfasst.

3. ECPR-Masterelektrode nach Anspruch 1 oder 2, wobei die Blindelementstruktur als eine periodische Wiederholung einer vorbestimmten Strukturdichte angeordnet ist.

4. ECPR-Masterelektrode nach einem der Ansprüche 1 bis 3, wobei der Blindelementbereich (302) durch einen kreisförmigen Außenumfang begrenzt wird.

5. ECPR-Masterelektrode nach einem der Ansprüche 1 bis 3, wobei der Blindelementbereich (402) eine Vielzahl von Blindelement-Unterbereichen (412) umfasst, wobei die Abmessungen jedes Unterbereichs (412) weniger betragen als die Abmessungen der Chipbereiche (303, 403).

6. ECPR-Masterelektrode nach einem der Ansprüche 1 bis 5, wobei die topographische Struktur (107,407) sich radial über die Vorderseite des Trägerelements (101) von einer zentral ausgerichteten Position zu dem Rand des Trägerelements (101) hin erstreckt, und wobei das Trägerelement (101) eine ringförmige Ausnehmung außerhalb der kreisförmigen topographischen Struktur (107, 407) umfasst.

7. ECPR-Masterelektrode nach Anspruch 6, wobei die ringförmige Ausnehmung sich bis zum Rand des Trägerelements (101) erstreckt.

8. Verfahren zur Bereitstellung einer ECPR-Masterelektrode, umfassend den Schritt des:
Bereitstellens eines kreisförmigen Trägerelements, das eine elektrisch leitende Elektrodenoberfläche an einer Rückseite und eine topographische Struktur mit einer mindestens teilweise elektrisch isolierenden Oberseite an einer Vorderseite dieses Trägerelements aufweist, wobei die topographische Struktur eine Vielzahl elektrochemischer Zellen in dem Trägerelement umfasst, wobei jede der elektrochemischen Zellen einen Boden und mindestens eine Seitenwand umfasst, wobei der Boden eine elektrisch leitende Oberfläche aufweist, die mit der elektrisch leitenden Elektrodenoberfläche an der Rückseite durch das Trägerelement hindurch leitfähig verbunden ist,
wobei der Schritt des Bereitstellens der topographischen Struktur umfasst:
Verteilen der topographischen Struktur über eine Chipstruktur und eine Blindelementstruktur, und
Verteilen der Chipstruktur über einen Vorrichtungsbereich, der mindestens einen rechteckigen Chipbereich umfasst, während die Blindelementstruktur über einen Blindelementbereich verteilt wird, der den Vorrichtungsbereich umgibt.

9. Verfahren nach Anspruch 8, wobei die topographische Struktur durch ein erstes Lithographieverfahren, das den Vorrichtungsbereich definiert, und einen zweiten Lithographieschritt, der den Blindelementbereich definiert, bereitgestellt wird.

10. Verfahren nach Anspruch 9, wobei das erste Lithographieverfahren ein Stepper- oder Scannerverfahren ist.

11. Verfahren nach Anspruch 9 oder 10, wobei das zweite Lithographieverfahren ein Stepperverfahren, Scannerverfahren oder ein Mask-Aligner-Verfahren ist.

12. Verfahren nach einem der Ansprüche 8 bis 11, weiter den Schritt des Bereitstellens einer ringförmigen Ausnehmung umfassend, die sich vom Rand des Trägerelements zu dem Blindelementbereich hin erstreckt.

## Revendications

1. Électrode-maître de type ECPR (100, 400) comprenant :
un élément circulaire (101) faisant office de support possédant une surface d'électrode électroconductrice (106) sur un côté arrière (104) et un motif topographique (107, 407) comprenant un sommet (108) procurant une isolation électrique au moins partielle sur un côté avant (105) dudit élément (101) faisant office de support ;
ledit motif topographique comprenant plusieurs cellules électrochimiques (109) dans ledit élément (101) faisant office de support, chacune desdites cellules électrochimiques comprenant une base (111) et au moins une paroi latérale (112), ladite base possédant une surface électroconductrice (113) reliée par conduction à la surface d'électrode électroconductrice (106) à travers l'élément (101) faisant office de support ; dans laquelle
ledit motif topographique (107, 407) comprend un motif faisant office de microcircuit intégré et un motif non fonctionnel ; et dans laquelle
ledit motif faisant office de microcircuit intégré est distribué sur une zone faisant office de dispositif (301, 401) comprenant au moins une zone rectangulaire (303, 403) faisant office de microcircuit intégré, tandis que ledit motif non fonctionnel est distribué sur une zone non fonctionnelle (302, 402) entourant ladite zone faisant office de dispositif (301, 401).

2. Électrode-maître de type ECPR selon la revendication 1, dans laquelle ladite zone faisant office de dispositif (301, 401) comprend plusieurs zones rectangulaires (303, 403) faisant office de microcircuits intégrés, arrangées en position adjacente.

3. Électrode-maître de type ECPR selon la revendication 1 ou 2, dans laquelle ledit motif non fonctionnel est arrangé sous la forme d'une répétition périodique d'une densité de motifs prédéterminée.

4. Électrode-maître de type ECPR selon l'une quelconque des revendications 1 à 3, dans laquelle ladite zone non fonctionnelle (302) se termine par une périphérie circulaire.

5. Électrode-maître de type ECPR selon l'une quelconque des revendications 1 à 3, dans laquelle ladite zone non fonctionnelle (402) comprend plusieurs zones non fonctionnelles secondaires (412), les dimensions de chaque zone secondaire (412) étant inférieures aux dimensions des zones (303, 403) faisant office de microcircuits intégrés.

6. Électrode-maître de type ECPR selon l'une quelconque des revendications 1 à 5, dans laquelle le motif topographique (107, 407) s'étend en direction radiale sur le côté avant dudit élément (101) faisant office de support depuis une position en alignement central en direction du bord dudit élément (101) faisant office de support, et dans laquelle l'élément (101) faisant office de support comprend un évidement annulaire à l'extérieur du motif topographique circulaire (107, 407).

7. Électrode-maître de type ECPR selon la revendication 6, dans laquelle ledit évidement annulaire s'étend jusqu'au bord de l'élément (101) faisant office de support.

8. Procédé pour procurer une électrode-maître de type ECPR, comprenant l'étape consistant à :
procurer un élément circulaire faisant office de support possédant une surface d'électrode électroconductrice sur un côté arrière et un motif topographique comprenant un sommet procurant une isolation électrique au moins partielle sur un côté avant dudit élément faisant office de support, ledit motif topographique comprenant plusieurs cellules électrochimiques dans ledit élément faisant office de support, chacune desdites cellules électrochimiques comprenant une base et au moins une paroi latérale, ladite base possédant une surface électroconductrice reliée par conduction à la surface d'électrode électroconductrice à travers l'élément faisant office de support ;
dans lequel l'étape consistant à procurer ledit motif topographique comprend le fait de :
distribuer ledit motif topographique à travers un motif faisant office de microcircuit intégré et un motif non fonctionnel ; et
distribuer ledit motif faisant office de microcircuit intégré à travers une zone faisant office de dispositif comprenant au moins une zone rectangulaire faisant office de microcircuit intégré, tout en distribuant ledit motif non fonctionnel à travers une zone non fonctionnelle qui entoure ladite zone faisant office de dispositif.

9. Procédé selon la revendication 8, dans lequel ledit motif topographique est fourni via un premier procédé de lithographie définissant ladite zone faisant office de dispositif et un deuxième étape de lithographie définissant ladite zone non fonctionnelle.

10. Procédé selon la revendication 9, dans lequel ledit premier procédé de lithographie est un procédé faisant appel à un stepper ou à un scanner.

11. Procédé selon la revendication 9 ou 10, dans lequel ledit deuxième procédé de lithographie est un procédé faisant appel à un stepper, un procédé faisant appel à un scanner ou un procédé faisant appel à une aligneuse de masque.

12. Procédé selon l'une quelconque des revendications 8 à 11, comprenant en outre l'étape consistant à procurer un évidement annulaire qui s'étend à partir du bord de l'élément faisant office de support, en direction de la zone non fonctionnelle.
